# EUROPÄISCHE PATENTSCHRIFT

(11) **EP 3 696 939 B1**
(45) Veröffentlichungstag und Bekanntmachung des Hinweises auf die Patenterteilung: **13.05.2026**
(21) Anmeldenummer: 20157743.4
(22) Anmeldetag: 17.02.2020
(51) Int. Cl.: H02J 7/02, H02J 7/32

(54) **ERDERANLAGE UND VERFAHREN ZUM ABLEITEN VON WECHSELSTROM VON EINEM STAHLBAUWERK**
EARTHING SYSTEM AND METHOD FOR DISSIPATING ALTERNATING CURRENT FROM A STEEL STRUCTURE
INSTALLATION DE MISE À LA TERRE ET PROCÉDÉ DE DÉRIVATION DU COURANT ALTERNATIF D'UNE CONSTRUCTION EN ACIER

(30) Priorität: 18.02.2019 DE 102019104058
(43) Veröffentlichungstag der Anmeldung: 19.08.2020
(73) Patentinhaber: Open Grid Europe GmbH, 45141 Essen (DE); SET Selected Electronic Technologies GmbH, 22880 Wedel (DE)
(72) Erfinder: Kaiser, Frank, 45279 Essen (DE); Korupp, Karl, 22559 Hamburg (DE); Zimmer, Waldemar, 25337 Elmshorn (DE)
(74) Vertreter: Harlacher, Mechthild

(56) Entgegenhaltungen:
- CN-A- 106 597 113
- CN-A- 106 707 098
- DE-A1- 2 546 694

## Beschreibung

Die Erfindung betrifft eine Erderanlage zum Ableiten von Wechselstrom von einem Stahlbauwerk, wobei die Erderanlage eine Erdungselektrode aufweist, die elektrisch mit dem Stahlbauwerk verbunden ist Ferner betrifft die Erfindung ein Verfahren zum Ableiten von Wechselstrom von einem Stahlbauwerk mittels mindestens einer Erderanlage, wobei die Erderanlage eine Erdungselektrode aufweist, die elektrisch mit dem Stahlbauwerk verbunden ist, wobei das Stahlbauwerk als erdverlegte kathodisch geschützte und mit Wechselstrom beeinflusste Rohrleitung ausgebildet ist.

Die CN 106 707 098 A offenbart ein Online-Überwachungsgerät und dient zur Online-Überwachung und Positionierung von Freileitungsentladungen, d. h. zur Fehlerortbestimmung in Freileitungen. Das Online-Überwachungsgerät weist ein Transformatorbauteil auf, um den Strom des Erdungsdrahts eines Stahlbauwerks zu überwachen. Der Erdungsdraht bzw. die Erdungselektrode des Stahlbauwerks verläuft zum Zweck der Überwachung durch einen magnetischen Ring des Transformatorbauteils.

Die CN 106 597 113 A zeigt ein Online-Prüfgerät für den Erdwiderstand eines Strommasten. Mit dem Online-Prüfgerät soll die Messung des Erdwiderstands vereinfacht werden, insbesondere eine Messung ermöglicht werden, ohne den Erdungsableiter trennen zu müssen. Zwei parallele Erdungsleitungen sind jeweils mit einem Erfassungskopf versehen. Zusätzlich befindet sich eine Hilfselektrode im Boden. Je eine obere Spule und je eine untere Spule und die Hilfselektrode sind mit einem Signalverarbeitungsmodul zur Steuerung und Datenverarbeitung verbunden. Die Erdungsleitungen verlaufen jeweils mittig durch die Spulen.

Die DE 25 46 694 A1 zeigt ein Mess-Sendegerät für Hochspannungsleitungen. Ein Umwandlungs-Digitalisierungsteil ordnet, auf dem Betriebspotenzial des Leiters, der Hochspannungsleitung digitale Werte zu. Eine oder mehrere elektrische oder nichtelektrische Größen der Hochspannungsleitung, welche einem Hochfrequenzsendeteil zugeführt werden, werden in ein Hochfrequenzsignal überführt, welches mit einer geeigneter Antenne gerichtet oder ungerichtet oder entlang der Hochspannungsleitung ausgestrahlt wird, wobei die für den Betrieb nötige Energie dem Umwandlungs-Digitalisierungsteil und dem Hochfrequenzsendeteil mit geeigneter Antenne von einem Netzteil, welches energetisch von Strom im Leiter der Hochspannungsleitung versorgt wird, geliefert wird. Das Netzteil enthält einen Umfass-Ringtransformator, so dass der Leiter der Hochspannungsleitung als primäre Wicklung wirkt und die in die sekundäre Wicklung induzierte Spannung mit geeigneten Gleichrichterkreisen in Gleichspannung mit dem Hochspannungsleiter-Betriebspotential als Nullpotential umgewandelt wird. Zur Konstanthaltung der Spannung dient ein Akkumulator, der immer dann aufgeladen wird, wenn der Strom in der Hochspannungsleitung groß genug ist.

Hochspannungsfreileitungen koppeln durch ihre elektromagnetischen Felder Wechselspannungen in Stahlbauwerke ein. Es können hohe Berührungsspannungen zwischen dem Stahlbauwerk und der Erde entstehen. Zu Spitzenlastzeiten, Erdkurzschlüssen oder bei einer Asymmetrie der parallel verlaufenden Hochspannungsfreileitungen können die in ein Stahlbauwerk eingekoppelten Spannungen hohe Werte erreichen. Daher werden Erderanlagen zum Schutz von Personen und Tieren eingesetzt.

Bei Rohrleitungen ist die Erdung zur Begrenzung der dauernd vorhandenen Berührungsspannung auf Werte <60V zum Schutz des Personals vorgeschrieben.

Zur Begrenzung der Berührungsspannung bei Dauerbeeinflussung, d. h. elektromagnetisch eingekoppelten Berührungsspannungen können Erderanlagen verwendet werden, die direkt mit dem Stahlbauwerk verbunden sind.

Eine Erderanlage weist mindestens eine Erdungselektrode, d. h. ein elektrisch leitfähiges Element auf, das in elektrischem Kontakt mit der Erde steht, um den Wechselstrom abzuleiten und eine Wechselspannungsbegrenzung beispielsweise einer Rohrleitung zu erreichen.

In der Praxis werden Erderanlagen vor Ort manuell in regelmäßigen Abständen dahingehend überprüft, ob die Funktionsfähigkeit gegeben ist, d. h. es wird überprüft, ob die für die Funktion wesentlichen Bauteile der Erderanlage bestimmungsgemäß in Funktion sind.

Jede Erderanlage muss zur Überprüfung der Funktionsfähigkeit vor Ort von Fachpersonal aufgesucht werden. Weil einzelne Erderanlagen räumlich weit entfernt voneinander sein können, ist die Überprüfung der Erderanlagen vor Ort mit großem personellen Aufwand verbunden.

Für die Überprüfung der Erderanlage vor Ort wird in der Praxis in deren Stromkreise ein Widerstandsmessgerät geschaltet. Dazu muss in die Stromkreise eingegriffen werden. Folglich ist der Aufwand für die Überprüfung vor Ort relativ hoch.

Aufgrund der zunehmenden regenerativen Stromerzeugung und des Monitorings der Hochspannungsübertragungen sind die Faktoren, die die Hochspannungsbeeinflussung von Stahlbauwerken, insbesondere von Rohrleitungen bestimmen, stark veränderlich. Daher besteht das Bedürfnis, jederzeit überprüfen zu können, wie hoch die Wechselstrombeeinflussung eines Stahlbauwerks aktuell ist, um sicherstellen zu können, dass die Erderanlagen ordnungsgemäß funktionieren.

Für Messungen vor Ort ist eine Spannungsversorgung für ein Messgerät erforderlich. Für kontinuierliche oder periodische Messungen wird relativ viel Strom benötigt. Um beispielsweise mehrere Messwerte pro Minute zu erhalten, benötigen handelsübliche Messgeräte bzw. Messwert-Erfassungseinheiten ca. 20mA/h bei 3,3Vdc Versorgungsspannung. An den Standorten der Erderanlagen ist in der Regel keine Niederspannungsversorgung (230Vac) vorhanden.

Handelsübliche Lithiumbatterien verfügen über eine Kapazität von ca. 19Ah. Derartige Batterien wären in weniger als 40 Tagen nicht mehr in der Lage, eine Messwert-Erfassungseinheit mit Strom zu versorgen, so dass häufige Batteriewechsel erforderlich wären.

Als alternative Spannungsversorgung für eine Messwert-Erfassungseinheit könnte ein Solarpanel genutzt werden, das jedoch anfällig für Vandalismus ist. Ferner ist an vielen Standorten keine ausreichend lange Sonneneinstrahlung gegeben.

Daher besteht die Aufgabe, eine Erderanlage zum Ableiten von Wechselstrom von einem Stahlbauwerk so weiterzubilden, dass eine Überwachung des Stahlbauwerks hinsichtlich der Höhe der Wechselstrombelastung und/oder eine Überwachung der Erderanlage hinsichtlich Funktionsfähigkeit unter Verwendung einer Messwert-Erfassungseinheit netzunabhängig möglich ist.

Diese Aufgabe wird durch eine Erderanlage mit den Merkmalen des Anspruchs 1 und ein Verfahren nach Anspruch 11 gelöst. Vorteilhafte Ausführungsformen sind Gegenstand von abhängigen Ansprüchen.

Das Stahlbauteil ist als erdverlegte kathodisch geschützte und mit Wechselstrom beeinflusste Rohrleitung ausgebildet, wobei eine Abgrenzeinheit elektrisch mit der Rohrleitung und der Erdungselektrode verbunden ist und eine gleichstrommäßige Trennung der Rohrleitung von der Erdungselektrode bewirkt. Bei der Rohrleitung kann es sich beispielsweise um eine Ferngasleitung handeln.

Erfindungsgemäß weist die Erderanlage ein Transformatorbauteil mit einer Primärwicklung und einer Sekundärwicklung auf, wobei der von der Rohrleitung abgeleitete Wechselstrom in die Primärwicklung einspeisbar ist, wobei die Primärwicklung in den Strompfad der Erderanlage in Reihe geschaltet ist, wobei die Sekundärwicklung die Ladespannung für einen Akkumulator zur Verfügung stellt und wobei eine Messwert-Erfassungseinheit dazu eingerichtet ist, kontinuierlich oder periodisch Strom-und Spannungswerte der Abgrenzeinheit zu erfassen und kontinuierlich oder periodisch zu speichern.

Mit dem Wechselstrom, der von dem Stahlbauwerk abgeleitet wird, wird ein Akkumulator gespeist, der zumindest eine Messwert-Erfassungseinheit vor Ort mit Strom versorgen kann, so dass netzunabhängig kontinuierliche Messungen hinsichtlich der Höhe der Wechselstrombeeinflussung und/oder eine Überwachung der Erderanlage hinsichtlich Funktionsfähigkeit ermöglicht wird bzw. werden.

Erfindungsgemäß wird die Primärwicklung in den Strompfad der Erderanlage in Reihe geschaltet. Anders ausgedrückt, wirkt der Strompfad der Erdungselektrode als Primärwicklung des Transformatorbauteils. Auf der Sekundärseite kann das Windungsverhältnis entsprechend der abgeleiteten Stromgröße der Erderanlage automatisch angepasst werden.

Eine vorteilhafte Ausgestaltung ist dadurch gekennzeichnet, dass die Sekundärwicklung des Transformatorbauteils elektrisch mit einer Ladeelektronik verbunden ist, die eingerichtet ist, die Betriebsspannung des Akkumulators einzustellen und/oder zu verstellen und/oder dass das Transformatorbauteil an unterschiedliche Wechselstrom-Bereiche anpassbar ist.

Vorzugsweise ist die Sekundärwicklung elektrisch mit einer Ladeelektronik verbunden, die eingerichtet ist, die Betriebsspannung des Akkumulators einzustellen und/oder zu verstellen.

Vorteilhafterweise ist das Transformatorbauteil an unterschiedliche Wechselstrom-Bereiche anpassbar. Das Transformatorbauteil wird an den zu erwarteten Ableitstrom der Erderanlage vorzugsweise einmalig manuell angepasst.

Vorzugsweise ist an den Akkumulator ein Spannungswandler angeschlossen, der vorzugsweise einstellbar ist. Der Spannungswandler kann beispielsweise eine Versorgungsspannung von 3,3Vdc bis 3,8Vdc zur Verfügung stellen.

Erfindungsgemäß ist eine Messwert-Erfassungseinheit, die von dem Akkumulator mit Strom versorgt wird, dazu eingerichtet, kontinuierlich oder periodisch Strom- und Spannungswerte der Erderanlage zu messen und zu speichern.

Eine bevorzugte Weiterbildung ist dadurch gekennzeichnet, dass eine Kommunikationseinheit in Kommunikationsverbindung mit der Messwert-Erfassungseinheit und einer Fernüberwachungseinheit steht.

Unter einer Kommunikationseinheit wird eine Einheit verstanden, die Daten mittels gängiger Schnittstellen und Datenübertragungs-Standards (WLAN, GSM, UMTS, USB, LAN usw.)drahtlos sendet. Unter Fernüberwachungseinheit wird eine externe Datenverarbeitungseinheit verstanden, die Daten empfangen und vorzugsweise verarbeiten und/oder anzeigen kann. Es kann sich beispielsweise um einen Server, eine Rechenanlage oder einen Tablet Computer handeln.

Nach der Erfindung ist die Messwert-Erfassungseinheit oder die Fernüberwachungseinheit dazu eingerichtet, den abgeleiteten Wechselstrom anzuzeigen und/oder aus den gemessenen Strom- und Spannungsmesswerten diejenigen Widerstandswerte, die für die Funktionsfähigkeit der Erderanlage charakterisierend sind, zu berechnen und anzuzeigen und/oder mit Sollwerten zu vergleichen.

Diejenigen Widerstandswerte, die für die Funktionsfähigkeit der Erderanlage charakterisierend sind, können erfindungsgemäß in der Messwert-Erfassungseinheit aus den gemessenen Strom-und Spannungsmesswerten berechnet und angezeigt werden. Wahlweise können die berechneten Werte mit Sollwerten verglichen werden. Bei einer Abweichung der berechneten Werte von den Sollwerten kann, ggf. abhängig von der Höhe der Abweichung, mittels der Kommunikationseinheit ein Signal zu der Fernüberwachungseinrichtung gesendet werden, um Maßnahmen zur Überprüfung der Erderanlage vor Ort einzuleiten.

Alternativ können die gemessenen Strom-und Spannungswerte mittels der Kommunikationseinheit an die Fernüberwachungseinheit gesendet werden, die sich in einer Steuerungszentrale befinden kann. Es werden zentral aus den dezentral gemessenen Strom-und Spannungswerte diejenigen Widerstandswerte, die für die Funktionsfähigkeit der Erderanlage charakterisierend sind, berechnet und angezeigt. Wahlweise können die berechneten Werte zentral mit Sollwerten verglichen werden. Bei einer Abweichung der berechneten Werte können, ggf. in Abhängigkeit von der Höhe der Abweichung Maßnahmen ergriffen werden, um die Funktionsfähigkeit der Erderanlage vor Ort zu überprüfen und wieder herzustellen.

Vorzugsweise ist die Erderanlage dadurch gekennzeichnet, dass die Messwert-Erfassungseinheit, die von dem Akkumulator mit Strom versorgt wird, dazu eingerichtet ist, kontinuierlich oder periodisch Strom- und Spannungswerte der Erderanlage zu messen und zu speichern, dass eine Kommunikationseinheit zur Übertragung der Messwerte in Kommunikationsverbindung mit der Messwert-Erfassungseinheit und einer Fernüberwachungseinheit steht, dass die Fernüberwachungseinheit dazu eingerichtet ist, die abgeleiteten Wechselspannung oder den abgeleiteten Wechselstrom anzuzeigen und/oder aus den übertragenen Strom- und Spannungsmesswerten diejenigen Widerstandswerte, die für die Funktionsfähigkeit der Erderanlage charakterisierend sind, zu berechnen und anzuzeigen und/oder mit Sollwerten zu vergleichen.

Die Messwerte werden vorzugsweise kontinuierlich oder periodisch zu der Fernüberwachungseinheit übertragen. Es kann jederzeit zentral geprüft werden, wie hoch die Wechselstrombeeinflussung eines Stahlbauwerks aktuell ist. Ferner können mehrere Erderanlagen zum Schutz gegen unzulässige Berührungsspannungen aufgrund Wechselstrombeeinflussung, zentral jederzeit und gleichzeitig dahingehend überwacht werden, ob ein betriebsbereiter Zustand gegeben ist.

Mittels der zentralen Fernüberwachung kann kontinuierlich oder periodisch zu gewählten Zeitpunkten oder Zeitspannen ohne personellen Aufwand geprüft werden, ob die maßgeblichen Komponenten der Erderanlage für ihren Bestimmungszweck die erforderliche Funktionsfähigkeit aufweisen. Sicherheitsmängel, die Menschen oder Tiere gefährden könnten, werden zeitnah erkannt.

Bei der Kommunikationseinheit kann es sich um ein Modem oder ein ähnliches Bauteil handeln. Es kann sich um ein gesondertes Bauteil handeln. Vorzugsweise ist die Kommunikationseinheit in die Messwert-Erfassungseinheit integriert und bildet mit diesem eine Baueinheit.

Erfindungsgemäß ist die Messwert-Erfassungseinheit dazu eingerichtet, zumindest den Erdausbreitungswiderstand der Erderanlage zu berechnen.

Alternativ ist vorteilhafterweise die Fernüberwachungseinheit dazu eingerichtet, zumindest den Erdausbreitungswiderstand der Erderanlage zu berechnen, wobei parallel zu der Erderanlage ein Hilfserder geschaltet ist, wobei die Erderanlage einen ersten Strom-Messwiderstand aufweist, an dem der Gesamt-Wechselstrom, der über die Erderanlage fließt, messbar ist, wobei die Messwert-Erfassungseinheit dazu eingerichtet ist, die Wechselspannung zwischen der Erdungselektrode und der Rohrleitung und die Wechselspannung zwischen der Erdungselektrode und dem Hilfserder zu messen und wobei die Fernüberwachungseinheit dazu eingerichtet ist, aus der Differenz der gemessenen Wechselspannungen dividiert durch den gemessenen Gesamt-Wechselstrom den Erdausbreitungswiderstand der Erderanlage zu berechnen.

Der Erdausbreitungswiderstand sollte möglichst niederohmig sein. Durch die kontinuierliche Fernüberwachung kann sichergestellt werden, dass die Erderanlage ordnungsgemäß arbeitet.

Nach der Erfindung ist anstelle der Fernüberwachungseinheit die Messwert-Erfassungseinheit dazu eingerichtet, aus der Differenz der gemessenen Wechselspannungen dividiert durch den gemessenen Gesamt-Wechselstrom den Erdausbreitungswiderstand der Erderanlage zu berechnen.

Erfindungsgemäß ist die Erderanlage dadurch gekennzeichnet, dass die Messwert-Erfassungseinheit dazu eingerichtet ist, Strom- und Spannungswerte der Abgrenzeinheit zu messen und zu speichern, dass die Messwert-Erfassungseinheit oder die Fernüberwachungseinheit dazu eingerichtet ist, aus den gemessenen Strom- und Spannungsmesswerten diejenigen Widerstandswerte, die für die Funktionsfähigkeit der Abgrenzeinheit charakterisierend sind, zu berechnen und anzuzeigen und/oder mit Sollwerten zu vergleichen.

Die berechneten Werte, die für die Funktionsfähigkeit der Abgrenzeinheit charakterisierend sind, werden in der Messwert-Erfassungseinheit vor Ort oder einer Fernüberwachungseinheit, die sich in einer Überwachungszentrale befinden kann, berechnet angezeigt. Wahlweise können die berechneten Werte mit Sollwerten verglichen werden und aus dem Vergleich Maßnahmen abgeleitet werden.

Im Rahmen der Erfindung ist die Messwert-Erfassungseinheit dazu eingerichtet ist, kontinuierlich oder periodisch Strom-und Spannungswerte der Abgrenzeinheit zu messen und zu speichern, wobei die Kommunikationseinheit zur Übertragung der Messwerte in Kommunikationsverbindung mit der Messwert-Erfassungseinheit und der Fernüberwachungseinheit steht, wobei die Fernüberwachungseinheit dazu eingerichtet ist, aus den übertragenen Strom- und Spannungsmesswerten diejenigen Widerstandswerte, die für die Funktionsfähigkeit der Abgrenzeinheit charakterisierend sind, zu berechnen und anzuzeigen und/oder mit Sollwerten zu vergleichen.

Eine vorteilhafte Ausgestaltung der Erfindung besteht darin, dass die Abgrenzeinheit ein erstes Abgrenzmodul und ein dazu parallel geschaltetes zweites Abgrenzmodul aufweist, dass das erste Abgrenzmodul als Reihenschwingkreis ausgebildet ist, dass das zweite Abgrenzmodul einen Schalter aufweist, der schließt, wenn eine in die Rohrleitung induzierte Wechselspannung einen eingestellten Wechselspannungs-Schwellwert überschreitet, dass sich in dem als Reihenschwingkreis ausgebildeten ersten Abgrenzmodul ein zweiter Strom-Messwiderstand befindet und dass die Messwert-Erfassungseinheit dazu eingerichtet ist, die Wechselspannung über der Erderanlage zu messen, den Gesamt-Wechselstrom der über die Erderanlage fließt, an dem ersten Strom-Messwiderstand und den Teil-Wechselstrom, der über das erste Abgrenzmodul fließt, an dem zweiten Strom-Messwiderstand zu messen und dass die Fernüberwachungseinheit dazu eingerichtet ist, aus der Wechselspannung der Erderanlage dividiert durch den Teil-Wechselstrom den Innenwiderstand des ersten Abgrenzmoduls zu berechnen und aus der Wechselspannung dividiert durch den Gesamt-Wechselstrom der Erderanlage den Innenwiderstand des zweiten Abgrenzmoduls zu berechnen.

Alternativ kann anstelle der Fernüberwachungseinheit die Messwert-Überwachungseinheit dazu eingerichtet sein, aus der Wechselspannung der Erderanlage dividiert durch den Teil-Wechselstrom den Innenwiderstand des ersten Abgrenzmoduls zu berechnen und aus der Wechselspannung dividiert durch den Gesamt-Wechselstrom der Erderanlage den Innenwiderstand des zweiten Abgrenzmoduls zu berechnen.

Das zweite Abgrenzmodul kann beliebig ausgebildet sein. Es kann sich um eine kapazitive Abgrenzeinheit, die aus Elektrolytkondensatoren mit Schutzbeschaltung besteht, handeln. Alternativ kann eine Thyristor-Abgrenzeinheit verwendet werden. Schließlich kann das zweite Abgrenzmodul als eine reine kapazitive Abgrenzeinheit ausgebildet sein.

Nach einem weiteren vorteilhaften Merkmal der Erfindung ist das System dadurch gekennzeichnet, dass die Messwert-Erfassungseinheit zusätzlich dazu eingerichtet ist, an dem ersten Strom-Messwiderstand den Gesamt-Gleichstrom, der über die Erderanlage fließt und/oder an dem zweiten Strom-Messwiderstand den Teil-Gleichstrom, der über das erste Abgrenzmodul fließt, zu messen und dass die Fernüberwachungseinheit dazu eingerichtet ist, die gemessenen Gleichstromwerte zur Erkennung von Gleichstrom-Leckströmen anzuzeigen.

Die Fernüberwachung von möglichen Gleichstrom-Leckströmen, die aufgrund des kathodischen Schutzes entstehen können, ist in der Praxis sehr wichtig, weil der Schutzstrom, der zum Schutz der Rohrleitung dient, nicht abgeleitet werden darf, weil sich ansonsten der Schutzstrombedarf erhöhen würde.

Die Aufgabe wird ferner durch das folgende Verfahren gelöst:
Verfahren zum Ableiten von Wechselstrom von einem Stahlbauwerk mittels mindestens einer Erderanlage, wobei die Erderanlage eine Erdungselektrode aufweist, die elektrisch mit dem Stahlbauwerk verbunden ist, wobei das Stahlbauwerk als erdverlegte kathodisch geschützte und mit Wechselstrom beeinflusste Rohrleitung ausgebildet ist und eine Abgrenzeinheit aufweist, die elektrisch mit dem Stahlbauwerk und der Erdungselektrode verbunden ist und eine gleichstrommäßige Trennung des Stahlbauwerks von der Erdungselektrode bewirkt, wobei die Erderanlage elektrisch mit einem Transformatorbauteil mit einer Primärwicklung und einer Sekundärwicklung verbunden ist, wobei die Primärwicklung in den Strompfad der Erderanlage in Reihe geschaltet ist, wobei der von der Erderanlage abgeleitete Wechselstrom in die Primärwicklung des Transformatorbauteils eingespeist wird und wobei die Sekundärwicklung die Ladespannung für einen Akkumulator zur Verfügung stellt und wobei mittels einer Messwert-Erfassungseinheit kontinuierlich oder periodisch Strom-und Spannungswerte der Abgrenzeinheit erfasst und kontinuierlich oder periodisch gespeichert werden.

Vorzugsweise ist die Sekundärwicklung des Transformatorbauteil elektrisch mit einer Ladeelektronik verbunden, mit der die Betriebsspannung des Akkumulators eingestellt und/oder verändert wird und/oder das Transformatorbauteil an unterschiedliche Wechselstrom-Bereiche anpassbar.

Vorzugsweise ist an den Akkumulator ein Spannungswandler angeschlossen, der vorzugsweise einstellbar ist.

Der Akkumulator kann eine Messwert-Erfassungseinheit netzunabhängig mit Strom versorgen, so dass kontinuierliche Messungen und eine Fernüberwachung der Erderanlage möglich sind.

Eine Weiterentwicklung des Verfahrens ist gekennzeichnet durch folgende Schritte,
- Kontinuierliches Erfassen und Speichern von Strom- und Spannungswerten der Erderanlage vor Ort mittels mindestens einer Messwert-Erfassungseinheit, die von dem Akkumulator mit Strom versorgt wird,
- Übertragen der Messwerte mittels einer Kommunikationseinheit zu einer Fernüberwachungseinheit,
- Anzeigen der Wechselspannung oder des Wechselstroms, der das Stahlbauwerk beeinflusst und/oder
- Berechnen von Widerstandswerten, die für die Funktionsfähigkeit der Erderanlage charakterisierend sind, aus den übertragenen Strom- und Spannungsmesswerten und Anzeigen und/oder Vergleichen der berechneten Widerstandswerte mit Sollwerten mittels der Fernüberwachungseinheit.

Die Messwerte der Messwert-Erfassungseinheit werden vorzugsweise kontinuierlich oder periodisch zu der Fernüberwachungseinheit übertragen. Der Wechselstrom wird primär zum Schutz gegen unzulässige Berührungsspannungen von dem Stahlbauwerk abgeleitet. Mittels des Verfahrens, welches eine Fernüberwachung ermöglicht, kann jederzeit sichergestellt werden, dass die Sicherheit von Personen oder Tieren nicht gefährdet ist.

Die Fernüberwachung ist aufwandsarm, weil Personalaufwand für eine Überprüfung der Erderanlage vor Ort vermieden wird. Es wird ferner die Sicherheit und die Zuverlässigkeit von Erderanlagen dadurch erhöht, dass eine kontinuierliche oder regelmäßige Überwachung in kurzen Abständen durchgeführt werden kann.

Eine vorzugsweise Ausgestaltung ist dadurch gekennzeichnet, dass mittels der Messwert-Erfassungseinheit der Gesamt-Wechselstrom, der über die Erderanlage fließt, mittels eines Strom-Messwiderstandes gemessen wird und die Wechselspannung zwischen der Erderanlage und der Rohrleitung und die Wechselspannung zwischen der Erdungselektrode und einem Hilfserder gemessen werden, dass die Messwerte mittels der Kommunikationseinheit zu der Fernüberwachungseinheit übertragen werden und dass mittels der Fernübertragungseinheit aus der Wechselspannungsdifferenz zwischen der Erdungselektrode und dem Hilfserder dividiert durch den Gesamt-Wechselstrom der Erdausbreitungswiderstand der Erderanlage berechnet wird.

Das erfindungsgemäße Verfahren ist ferner dadurch gekennzeichnet, dass die Messwert-Erfassungseinheit dazu eingerichtet ist, kontinuierlich oder periodisch Strom- und Spannungswerte der Abgrenzeinheit zu messen und zu speichern, dass die Kommunikationseinheit die Messwerte zu einer Fernüberwachungseinheit überträgt und dass die Fernüberwachungseinheit dazu eingerichtet ist, aus den übertragenen Strom- und Spannungsmesswerten diejenigen Widerstandswerte, die für die Funktionsfähigkeit der Abgrenzeinheit charakterisierend sind, zu berechnen und anzuzeigen und/oder mit Sollwerten zu vergleichen.

Für den Fall, dass die Abgrenzeinheit ein erstes Abgrenzmodul und ein zweites Abgrenzmodul aufweist, welches zum ersten Abgrenzmodul parallel geschaltet ist und wobei das erste Abgrenzmodul als Reihenschwingkreis ausgebildet ist, ist eine Weiterbildung des Verfahrens dadurch kennzeichnet, dass der Teil-Wechselstrom, der über das erste Abgrenzmodul fließt, mittels eines zweiten Strom-Messwiderstandes gemessen wird und dass mittels der Fernüberwachungseinheit aus der Wechselspannung der Erderanlage dividiert durch den Teil-Wechselstrom des ersten Abgrenzmoduls der Innenwiderstand des ersten Abgrenzmoduls berechnet und aus der Wechselspannung über der Erderanlage dividiert durch den Gesamt-Wechselstrom der Erderanlage der Innenwiderstand des zweiten Abgrenzmoduls berechnet werden. Dabei wird unter Wechselspannung der Erderanlage die Spannung zwischen der Erdungselektrode und der Rohrleitung verstanden.

Bei einer vorzugsweisen Ausgestaltung wird mittels der Messwert-Erfassungseinheit der Gesamt-Gleichstrom, der über die Erderanlage fließt, an dem ersten Strom-Messwiderstand vorzugsweise kontinuierlich oder in Intervallen gemessen. Alternativ oder zusätzlich wird der Teil-Gleichstrom, der über das erste Abgrenzmodul fließt, an einem zweiten Strom-Messwiderstand gemessen, der sich in dem als Reihenschwingkreis ausgebildeten ersten Abgrenzmoduls befindet und dass mittels der Fernüberwachungseinheit die gemessenen Gleichstromwerte zur Erkennung von Gleichstrom-Leckströmen angezeigt werden.

Die Erfindung, weitere Vorteile sowie das technische Umfeld werden nachfolgend anhand einer bevorzugten Ausführungsform beispielhaft unter Bezugnahme auf die beigefügten Zeichnungen näher erläutert. Die Erfindung soll durch die gezeigten Ausführungsbeispiele nicht eingeschränkt werden. Es ist auch möglich, Teilaspekte der in den Figuren erläuterten Merkmale mit anderen Merkmalen aus anderen Figuren und/oder der Beschreibung zu kombinieren.

Es zeigen in schematischer Darstellung:

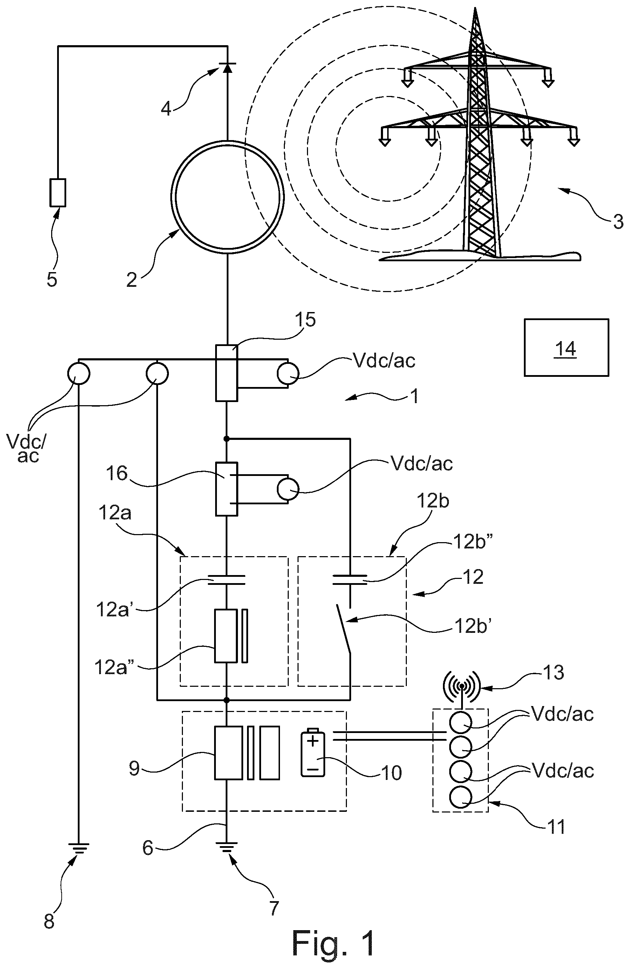

- Figur 1:: eine Erderanlage zum Ableiten von Wechselstrom von einem Stahlbauwerk.

In Figur 1 ist eine Erderanlage 1 zum Ableiten von Wechselstrom von einem Stahlbauwerk in Form einer erdverlegten kathodisch geschützten Rohrleitungen 2 dargestellt, die mit Wechselstrom von einer benachbarten Hochspannungsfreileitung 3 beeinflusst wird. Im Folgenden wird zur Vereinfachung der allgemeine Begriff "Stahlbauwerk" durch "Rohrleitung" ersetzt. Die Rohrleitung 2 ist mittels eines Schutzstromgerätes 4 kathodisch geschützt, das sekundärseitig elektrisch einerseits mit der Rohrleitung 2 und andererseits mit mindestens einer erdverlegten Anode 5 verbunden ist. Die Rohrleitung 2 und die Anode 5 sind im Erdreich verlegt, das bekanntlich eine elektrolytische Wirkung hat. Der Schutzstrom dient dazu, an die Rohrleitung 2 eine elektrische negative Spannung anzulegen, um Korrosion zu verhindern.

Die Erderanlage zum Schutz der Rohrleitung gegen unzulässige Berührungsspannung weist eine Anschlussleitung 6 und eine erdverlegte Erdungselektrode 7 auf. Über den Strompfad der Erderanlage 1 wird die Wechselspannung, die die Rohrleitung 2 beaufschlagt, auf einen unkritischen Wert herabgesetzt. Die in die Rohrleitung 2 eingekoppelten Wechselspannungen werden somit auf einen für Personen kritischen Berührungsspannungspegel begrenzt. Die Erderanlage 1 weist vorzugsweise eine einzige Erdungselektrode 1 auf. Parallel zu der Erderanlage 1 ist ein Hilfserder 8 geschaltet, der zu Messzwecken dient.

An dem Standort der Erderanlage ist keine Niederspannungsversorgung (230Vac) vorhanden, so dass erfindungsgemäß der abgeleitete Wechselstrom in die Primärwicklung eines Transformatorbauteil 9 eingespeist wird. Die Sekundärwicklung stellt die Ladespannung für einen Akkumulator 10 zur Verfügung, der zumindest eine Messwert-Erfassungseinheit 11 netzunabhängig mit Strom versorgt. Das Transformatorbauteil 9 kann beispielsweise als Ringkerntransformator ausgebildet sein.

Die Sekundärwicklung des Transformatorbauteil 9 ist auf nicht dargestellte Weise elektrisch mit einer nicht dargestellten Ladeelektronik verbunden, mit der die jeweilige Betriebsspannung des Akkumulators 10 eingestellt und/oder verstellt werden kann. Das Transformatorbauteil 9 ist an unterschiedliche Wechselstrom-Bereiche anpassbar.

An den Akkumulator 10 ist ein nicht dargestellter Spannungswandler angeschlossen, der vorzugsweise einstellbar ist.

Mittels einer Abgrenzeinheit 12, die einerseits elektrisch mit der Rohrleitung 2 und anderseits elektrisch mit der Erdungselektrode 8 verbunden ist, wird eine gleichstrommäßige Trennung der Rohrleitung 2 von der Erdungselektrode 7 bewirkt.

Die Abgrenzeinheit 12 weist ein erstes Abgrenzmodul 12a auf, welches als Reihenschwingkreis ausgebildet ist, bei dem es sich um einen ungepolten Folienkondensator 12a' in Reihenschaltung mit einer Drosselspule 12a" handelt.

Die Abgrenzeinheit 12 weist ein zweites Abgrenzmodul 12b auf, das zum ersten Abgrenzmodul 12a parallel geschaltet ist und dass im Ausführungsbeispiel als sogenannte Thyristor-Abgrenzeinheit ausgebildet ist und welches einen elektronischen Leistungsschalter 12b' und einen polarisierten Elektrolytkondensator 12b" aufweist. Der Leistungsschalter 12b' schließt, wenn ein in die Rohrleitung 2 induzierter Wechselstrom einen eingestellten Wechselspannungs-Schwellwert überschreitet und dient als Schutz für das erste Abgrenzmodul 12a, welches hochohmiger ist als das zweite Abgrenzmodul 12b. Andere Ausführungen des zweiten Abgrenzmoduls 12b sind möglich. So könnte auf den polarisierten Elektrolytkondensator 12b" verzichtet werden.

Die Einstellung der Schaltschwelle des Leistungsschalters 12b' erfolgt über ein nicht dargestelltes Steuerteil. Die aktuelle Wechselspannung, die mit dem Schwellwert bzw. der Schaltschwelle verglichen wird, kann auf einfache Art und Weise mittels des Hilfserders 9 gemessen werden.

Anstelle der Thyristor-Abgrenzeinheit könnte auch ein nach einem anderen Prinzip arbeitendes Abgrenzmodul eingesetzt werden. Anstelle des Leistungsschalters könnte auch ein mechanischer Schalter eingesetzt werden, der elektrisch ansteuerbar ist.

Die Messwert-Erfassungseinheit 11 weist eine integrierte Kommunikationseinheit 13 auf, die in Kommunikationsverbindung mit einer Fernüberwachungseinheit 14 steht und die gemessenen Daten mittels gängiger Schnittstellen und Datenübertragungs-Standards (WLAN, GSM, UMTS, USB, LAN usw.) überträgt.

Mittels der Messwert-Erfassungseinheit 11 werden kontinuierlich oder periodisch, vorzugsweise alle fünf Minuten Strom-und Spannungswerte der Erderanlage 6 und/oder der Abgrenzeinheit 13 erfasst und kontinuierlich oder periodisch, vorzugsweise jede Sekunde gespeichert. Die Kommunikationseinheit 13 dient der Übertragung der Messwerte zu der Fernüberwachungseinheit 14, die sich örtlich entfernt von dem Ort der Messungen in der Fernüberwachungszentrale des Betreibers der Rohrleitung oder einem Rechenzentrum befindet. Die gespeicherten Messwerte werden von der Kommunikationseinheit 13 kontinuierlich oder periodisch zu der Fernüberwachungseinheit 14 übertragen.

In der Fernüberwachungseinheit 14 wird kontinuierlich die Höhe des Wechselstroms, der die Rohrleitung beeinflusst, angezeigt, so dass auf einfache Art und Weise eine Fernüberwachung der jeweiligen Wechselstrombeeinflussung eines Stahlbauwerks ermöglicht wird.

Ferner werden aus den übertragenen Strom-/Spannungswerten in Echtzeit Widerstandswerte berechnet, die für die Funktionsfähigkeit der Erderanlage 1 und/oder der Abgrenzeinheit 12 charakterisierend sind.

Die Erderanlage weist einen ersten Strom-Messwiderstand 15 in Form eines Shunts, d. h. eines niederohmigen Widerstands auf, an dem kontinuierlich der Gesamt-Wechselstrom, der über die Erderanlage 1 fließt, gemessen wird. Die Messwert-Erfassungseinheit 11 erfasst kontinuierlich die Wechselspannung zwischen der Erdungselektrode 7 und der Rohrleitung 2 sowie die Wechselspannung zwischen der Erdungselektrode 7 und einem Hilfserder 8.

In der Fernüberwachungseinheit 14 wird kontinuierlich oder in Interwallen zentral aus der Differenz der gemessenen Wechselspannungen, dividiert durch den Gesamt-Wechselstrom, der über die Erdungsanlage 1 fließt, der Erdausbreitungswiderstand der Erderanlage 1 berechnet. Der Erdausbreitungswiderstand muss möglichst niederohmig sein, um den Wechselstrom zuverlässig abzuleiten. Wenn die Berechnung des Erdausbreitungswiderstand ergibt, dass der Erdausbreitungswiderstand zu hochohmig ist, können Reparaturmaßnahmen eingeleitet werden.

Zudem wird an einem zweiten Strom-Messwiderstand 16 in Form eines Shunts, der sich in dem Reihenschwingkreis, der das erste Abgrenzmodul 12a bildet, befindet, kontinuierlich oder periodisch, beispielsweise alle fünf Minuten, der Teil-Wechselstrom, der über den Reihenschwingkreis fließt, gemessen.

Die Fernüberwachungseinheit 14 errechnet zentral, vorzugsweise in Echtzeit, aus der Wechselspannung über der Erderanlage 1, d. h. aus der Wechselspannung zwischen der Erdungselektrode 7 und der Rohrleitung 2, dividiert durch den gemessenen Teil-Wechselstrom, gemessen an dem zweiten Strom-Messwiderstand 16, den Innenwiderstand des Reihenschwingkreises, der das erste Abgrenzmodul 12a bildet.

Die Fernüberwachungseinheit 14 errechnet ferner aus der Wechselspannung über der Erderanlage 1, dividiert durch den Gesamt-Wechselstrom, der über die Erderanlage 1 fließt, den Innenwiderstand des zweiten Abgrenzmoduls 12b der Abgrenzeinheit 13.

Die errechneten Innenwiderstands-Werte werden zentral angezeigt, um die Funktionsfähigkeit der Abgrenzeinheit zu überwachen und/oder um Veränderungen feststellen zu können.

Die berechneten Widerstandswerte können mit Sollwerten verglichen werden. Wenn die errechneten Werte in unzulässiger Weise von den Sollwerten abweichen, können unmittelbar Maßnahmen, insbesondere Reparaturmaßnahmen ergriffen werden, um den betriebsbereiten Zustand der Erderanlage und/oder der Abgrenzeinheit wieder herzustellen.

Mittels der Messwert-Erfassungseinheit 11 werden zusätzlich an dem ersten Strom-Messwiderstand 15 der Gesamt-Gleichstrom der über die Erderanlage fließt und/oder an dem zweiten Strom-Messwiderstand 16 der Teil-Gleichstrom, der über das erste Abgrenzmodul 12a fließt, gemessen und zu der Fernüberwachungseinheit übertragen.

Im Betriebszustand der Erderanlage darf kein Gleichstrom fließen, weil der kathodischer Schutzstrom nicht abgeleitet werden soll. Fließen dennoch Gleichströme, handelt es sich um unerwünschte Leckströme, die anhand der Messwerte, die von der Fernüberwachungseinheit 14 kontinuierlich oder periodisch zentral angezeigt werden, auf einfache Art und Weise im Rahmen der Fernüberwachung festgestellt werden können.

Mittels der Fernüberwachungseinheit 14 können aus den Messwerten zusätzliche Aussagen über die Funktionsfähigkeit weiterer Bauteile der Abgrenzeinheit 12 zentral abgeleitet werden:
Fließt ein geringerer Wechselstrom im Strompfad des ersten Abgrenzmoduls 12a in Form eines Reihenschwingkreises als im Hauptstrompfad der Erderanlage, ist das zweite Abgrenzmodul 12b über die Steuereinheit eingeschaltet worden. Die Ein- und Ausschaltpunkte der Steuereinheit werden einmalig bei der Inbetriebnahme eingestellt und protokoliert. Anhand der gemessenen Wechselspannung zwischen der Rohrleitung 2 und dem Hilfserder 9 und der Asymmetrie im Strompfad des ersten und des zweiten Abgrenzmodul 12a, 12b können diese Schaltpunkte zentral überprüft werden.

Es findet eine Fernüberwachung statt, unter der Maßnahmen von einer örtlich von der Rohrleitung und/oder der Erderanlage/Abgrenzenheit entfernten zentralen Stelle zu verstehen sind, die dazu dienen, jederzeit den Ist-Zustand der überwachten Einheit festzustellen und zu beurteilen.

Die vorstehend beschriebenen Ausführungsformen sind beispielhaft zu verstehen. Merkmale oder Verfahrensschritte, die mit Verweis auf eines der obigen Ausführungsbeispiele beschrieben worden sind, können auch in Kombination mit anderen Merkmalen oder Verfahrensschritten anderer beschriebener Ausführungsbeispiele verwendet werden, ohne den Schutzbereich der Patentansprüche zu verlassen.

Die Merkmale, welche zusammen mit anderen Merkmalen beschrieben sind, definieren unabhängig davon, ob sie in der Beschreibung, den Ansprüchen, den Figuren oder anderweitig offenbart sind, auch einzeln wesentliche Bestandteile der Erfindung.

Im Rahmen der Erfindung sind ohne weiteres Abwandlungen möglich. Mittels des mit abgeleitetem Wechselstrom gespeisten Akkumulators könnten vor Ort auch andere Geräte mit Strom versorgt werden.

Schließlich wird darauf hingewiesen, dass der Begriff "aufweisend" keine Bauteile oder Elemente ausschließt, dass Bezugszeichen in den Ansprüchen keine Einschränkung darstellen und dass "ein" oder "eine" eine Vielzahl einschließt.

### Bezugszeichenliste

- 1: Erderanlage
- 2: Stahlbauwerk / Rohrleitung
- 3: Hochspannungsfreileitung
- 4: Schutzstromgerät
- 5: Anode
- 6: Anschlussleitung
- 7: Erdungselektrode
- 8: Hilfserder
- 9: Transformatorbauteil
- 10: Akkumulator
- 11: Messwert-Erfassungseinheit
- 12: Abgrenzeinheit
- 12a: erstes Abgrenzmodul
- 12a': Folienkondensator
- 12a": Drossel
- 12b: zweites Abgrenzmodul
- 12b': Schalter
- 12b": Polarisierter Elektrolytkondensator
- 13: Kommunikationseinheit
- 14: Fernüberwachungseinheit
- 15: erster Strom-Messwiderstand
- 16: zweiter Strom-Messwiderstand

## Patentansprüche

1. Erderanlage zum Ableiten von Wechselstrom von einem Stahlbauwerk (2),
wobei die Erderanlage (1) eine Erdungselektrode (7) aufweist, die elektrisch mit dem Stahlbauwerk (2) verbunden ist,
wobei das Stahlbauwerk (2) als erdverlegte kathodisch geschützte und mit Wechselstrom beeinflusste Rohrleitung ausgebildet ist,
wobei eine Abgrenzeinheit (12) elektrisch mit dem Stahlbauwerk (2) und der Erdungselektrode (7) verbunden ist und eine gleichstrommäßige Trennung des Stahlbauwerks (2) von der Erdungselektrode (7) bewirkt,
wobei die Erderanlage ein Transformatorbauteil (9) mit einer Primärwicklung und einer Sekundärwicklung aufweist, wobei der abgeleitete Wechselstrom in die Primärwicklung einspeisbar ist, wobei die Primärwicklung in den Strompfad der Erderanlage in Reihe geschaltet ist, wobei die Sekundärwicklung die Ladespannung für einen Akkumulator (10) zur Verfügung stellt und wobei eine Messwert-Erfassungseinheit (11) dazu eingerichtet ist, kontinuierlich oder periodisch Strom-und Spannungswerte der Abgrenzeinheit (12) zu erfassen und kontinuierlich oder periodisch zu speichern.

2. Erderanlage nach Anspruch 1,
**dadurch gekennzeichnet, dass** die Sekundärwicklung des Transformatorbauteils (9) elektrisch mit einer Ladeelektronik verbunden ist, die eingerichtet ist, die Betriebsspannung des Akkumulators einzustellen und/oder zu verstellen und/oder dass das Transformatorbauteil (9) an unterschiedliche Wechselstrom-Bereiche anpassbar ist.

3. Erderanlage nach wenigstens einem der vorhergehenden Ansprüche,
**dadurch gekennzeichnet, dass** an den Akkumulator (10) ein Spannungswandler angeschlossen ist, der vorzugsweise einstellbar ist.

4. Erderanlage nach wenigstens einem der vorhergehenden Ansprüche,
**dadurch gekennzeichnet, dass** die Messwert-Erfassungseinheit (11), die von dem Akkumulator (10) mit Strom versorgt wird, dazu eingerichtet ist, kontinuierlich oder periodisch Strom- und Spannungswerte der Erderanlage zu messen und zu speichern.

5. Erderanlage nach Anspruch 4,
**dadurch gekennzeichnet, dass** eine Kommunikationseinheit (13) in Kommunikationsverbindung mit der Messwert-Erfassungseinheit (11) und einer Fernüberwachungseinheit (14) steht.

6. Erderanlage nach Anspruch 4 oder 5,
**dadurch gekennzeichnet, dass** die Messwert-Erfassungseinheit (11) oder die Fernüberwachungseinheit (14) dazu eingerichtet ist, die abgeleitete Wechselspannung anzuzeigen und/oder aus den gemessenen Strom- und Spannungsmesswerten diejenigen Widerstandswerte, die für die Funktionsfähigkeit der Erderanlage charakterisierend sind, zu berechnen und anzuzeigen und/oder mit Sollwerten zu vergleichen.

7. Erderanlage nach einem der Ansprüche 4 bis 6,
**dadurch gekennzeichnet, dass** die Messwert-Erfassungseinheit oder die Fernüberwachungseinheit (14) dazu eingerichtet ist, zumindest den Erdausbreitungswiderstand der Erderanlage (1) zu berechnen, dass parallel zu der Erderanlage (1) ein Hilfserder (8) geschaltet ist, dass die Erderanlage (1) einen ersten Strom-Messwiderstand (15) aufweist, an dem der Gesamt-Wechselstrom, der über die Erderanlage (1) fließt, messbar ist, dass die Messwert-Erfassungseinheit (11) dazu eingerichtet ist, die Wechselspannung zwischen der Erdungselektrode (7) und dem Stahlbauwerk (2) und die Wechselspannung zwischen der Erdungselektrode (7) und dem Hilfserder (8) zu messen und dass die Messwert-Erfassungseinheit oder die Fernüberwachungseinheit (14) dazu eingerichtet ist, aus der Differenz der gemessenen Wechselspannungen dividiert durch den gemessenen Gesamt-Wechselstrom den Erdausbreitungswiderstand der Erderanlage (19) zu berechnen.

8. Erderanlage nach Anspruch 1,
**dadurch gekennzeichnet, dass** die Messwert-Erfassungseinheit (11) dazu eingerichtet ist, Strom- und Spannungswerte der Abgrenzeinheit (12) zu messen und zu speichern, dass die Messwert-Erfassungseinheit oder die Fernüberwachungseinheit (14) dazu eingerichtet ist, aus den gemessenen Strom- und Spannungsmesswerten diejenigen Widerstandswerte, die für die Funktionsfähigkeit der Abgrenzeinheit (12) charakterisierend sind, zu berechnen und anzuzeigen und/oder mit Sollwerten zu vergleichen.

9. Erderanlage nach Anspruch 1,
**dadurch gekennzeichnet, dass** die Abgrenzeinheit (12) ein erstes Abgrenzmodul (12a) und ein dazu parallel geschaltetes zweites Abgrenzmodul (12b) aufweist, dass das erste **Ab**grenzmodul (12a) als Reihenschwingkreis ausgebildet ist, dass das zweite Abgrenzmodul (12b) einen Schalter (12b') aufweist, der schließt, wenn eine in die Rohrleitung induzierte Wechselspannung einen eingestellten Wechselspannungs-Schwellwert überschreitet, dass sich in dem als Reihenschwingkreis ausgebildeten ersten Abgrenzmodul (12a) ein zweiter Strom-Messwiderstand (16) befindet und dass die Messwert-Erfassungseinheit (11) dazu eingerichtet ist, die Wechselspannung über der Erderanlage zu messen, den Gesamt-Wechselstrom der über die Erderanlage (1) fließt, an dem ersten Strom-Messwiderstand (15) und den Teil-Wechselstrom der über das erste Abgrenzmodul (12a) fließt, an dem zweiten Strom-Messwiderstand (16) zu messen und dass die Messwert-Erfassungseinheit (11) oder die Fernüberwachungseinheit (14) dazu eingerichtet ist, aus der Wechselspannung der Erderanlage (1) dividiert durch den Teil-Wechselstrom den Innenwiderstand des ersten Abgrenzmoduls (12a) zu berechnen und aus der Wechselspannung dividiert durch den Gesamt-Wechselstrom der Erderanlage (1) den Innenwiderstand des zweiten Abgrenzmoduls (12b) zu berechnen.

10. Erderanlage nach einem der Ansprüche 1 oder **9,**
**dadurch gekennzeichnet, dass** die Messwert-Erfassungseinheit (11) zusätzlich dazu eingerichtet ist, an dem ersten Strom-Messwiderstand (15) den Gesamt-Gleichstrom, der über die Erderanlage (1) fließt und/oder an dem zweiten Strom-Messwiderstand (16) den Teil-Gleichstrom, der über das erste Abgrenzmodul (12a) fließt, zu messen und dass die Fernüberwachungseinheit (14) dazu eingerichtet ist, die gemessenen Gleichstromwerte zur Erkennung von Gleichstrom-Leckströmen anzuzeigen.

11. Verfahren zum Ableiten von Wechselstrom von einem Stahlbauwerk mittels mindestens einer Erderanlage, wobei die Erderanlage (1) eine Erdungselektrode (7) aufweist, die elektrisch mit dem Stahlbauwerk (2) verbunden ist, wobei das Stahlbauwerk (2) als erdverlegte kathodisch geschützte und mit Wechselstrom beeinflusste Rohrleitung ausgebildet ist und eine Abgrenzeinheit (12) aufweist, die elektrisch mit dem Stahlbauwerk (2) und der Erdungselektrode (7) verbunden ist und eine gleichstrommäßige Trennung des Stahlbauwerks (2) von der Erdungselektrode (7) bewirkt, wobei die Erderanlage (1) elektrisch mit einem Transformatorbauteil (9) mit einer Primärwicklung und einer Sekundärwicklung verbunden ist, wobei die Primärwicklung in den Strompfad der Erderanlage in Reihe geschaltet ist, wobei der von der Erderanlage (1) abgeleitete Wechselstrom in die Primärwicklung des Transformatorbauteils (9) eingespeist wird und wobei die Sekundärwicklung die Ladespannung für einen Akkumulator (10) zur Verfügung stellt und wobei mittels einer Messwert-Erfassungseinheit (11) kontinuierlich oder periodisch Strom-und Spannungswerte der Abgrenzeinheit (12) erfasst und kontinuierlich oder periodisch gespeichert werden.

12. Verfahren nach Anspruch 11,
**gekennzeichnet durch** folgende Schritte,
- Kontinuierliches Erfassen und Speichern von Strom- und Spannungswerten der Erderanlage (1) vor Ort mittels mindestens der Messwert-Erfassungseinheit (11), die mittels des Akkumulators (10) mit Strom versorgt wird,
- Übertragen der Messwerte mittels einer Kommunikationseinheit (13) zu einer Fernüberwachungseinheit (14),
- Anzeigen der Wechselspannung, die das Stahlbauwerk (2) beeinflusst oder Anzeigen des abgeleiteten Wechselstroms und/oder
- Berechnen von Widerstandswerten, die für die Funktionsfähigkeit der Erderanlage (1) charakterisierend sind, aus den übertragenen Strom- und Spannungsmesswerten und Anzeigen der berechneten Widerstandswerte und/oder Vergleichen der berechneten Widerstandswerte mit Sollwerten mittels der Fernüberwachungseinheit.

13. Verfahren nach der Anspruch 12,
**dadurch gekennzeichnet, dass** die Kommunikationseinheit die Messwerte der Messwert-Erfassungseinheit (11) zu der Fernüberwachungseinheit (14) überträgt und dass die Fernüberwachungseinheit (14) dazu eingerichtet ist, aus den übertragenen Strom- und Spannungsmesswerten diejenigen Widerstandswerte, die für die Funktionsfähigkeit der Abgrenzeinheit (12) charakterisierend sind, zu berechnen und anzuzeigen und/oder mit Sollwerten zu vergleichen.

## Claims

1. Earthing installation for dissipating alternating current from a steel structure (2),
wherein the earthing installation (1) has an earthing electrode (7) which is electrically connected to the steel construction (2),
wherein the steel construction (2) is in the form of an underground cathodically protected pipeline which is influenced with alternating current,
wherein a delimitation unit (12) is electrically connected to the steel construction (2) and the earthing electrode (7) and brings about a direct-current separation of the steel construction (2) from the earthing electrode (7),
wherein the earthing installation has a transformer component (9) with a primary coil and a secondary coil, wherein the dissipated alternating current can be fed into the primary coil, wherein the primary coil is connected in series in the current path of the earthing installation, wherein the secondary winding provides the charging voltage for an accumulator (10) and wherein a measurement value detection unit (11) is configured to continuously or periodically detect and continuously or periodically store current and voltage values of the delimitation unit (12).

2. Earthing installation according to claim 1,
**characterized in that** the secondary winding of the transformer component (9) is electrically connected to an electronic charging unit which is configured to set and/or adjust the operating voltage of the accumulator and/or **in that** the transformer component (9) can be adapted to different alternating-current ranges.

3. Earthing installation according to at least one of the preceding claims,
**characterized in that** a voltage transformer which is preferably adjustable is connected to the accumulator (10).

4. Earthing installation according to any one of the preceding claims, **characterized in that** the measurement value detection unit (11) which is supplied with power by the accumulator (10) is configured to continuously or periodically measure and store current and voltage values of the earthing installation.

5. Earthing installation according to claim 4,
**characterized in that** a communication unit (13) is in communicating connection with the measurement value detection unit (11) and a remote monitoring unit (14).

6. Earthing installation according to claim 4 or 5,
**characterized in that** the measurement value detection unit (11) or the remote monitoring unit (14) is configured to display the dissipated alternating-current voltage and/or to calculate and display the resistance values which are characterizing for the functionality of the earthing installation from the measured voltage and current measurement values and/or to compare them with desired values.

7. Earthing installation according to any one of claims 4 to 6,
**characterized in that** the measurement value detection unit or the remote monitoring unit (14) is configured to calculate at least the earthing propagation resistance of the earthing installation (1), **in that** an auxiliary earthing (8) is connected in parallel to the earthing installation (1), **in that** the earthing installation (1) has a first current measurement resistor (15) on which the overall alternating current flowing over the earthing installation (1) can be measured, **in that** the measurement value detection unit (11) is configured to measure the alternating-current voltage between the earthing electrode (7) and the steel construction (2) and the alternating-current voltage between the earthing electrode (7) and the auxiliary earthing (8) and **in that** the measurement value detection unit or the remote monitoring unit (14) is configured to calculate the earthing propagation resistance of the earthing installation (19) from the difference of the measured alternating-current voltages divided by the measured overall alternating current.

8. Earthing installation according to claim 1,
**characterized in that** the measurement value detection unit (11) is configured to measure and store current and voltage values of the delimitation unit (12), **in that** the measurement value detection unit or the remote monitoring unit (14) is configured to calculate and display the resistance values which are characterizing for the functionality of the delimitation unit (12) from the measured voltage and current measurement values and/or to compare them with desired values.

9. Earthing installation according to claim 1,
**characterized in that** the delimitation unit (12) has a first delimitation module (12a) and a second delimitation module (12b) connected parallel thereto, **in that** the first delimitation module (12a) is in the form of a series resonant circuit, **in that** the second delimitation module (12b) has a switch (12b') which closes when an alternating-current voltage which is induced in the pipeline exceeds a set alternating-current voltage threshold value, **in that** a second current measurement resistor (16) is located in the first delimitation module (12a) which is in the form of a series resonant circuit, and **in that** the measurement value detection unit (11) is configured to measure the alternating-current voltage across the earthing installation, the overall alternating current flowing over the earthing installation (1) on the first current measurement resistor (15) and the partial alternating current flowing over the first delimitation module (12a) on the second current measurement resistor (16), and **in that** the measurement value detection unit (11) or the remote monitoring unit (14) is configured to calculate the internal resistance of the first delimitation module (12a) from the alternating-current voltage of the earthing installation (1) divided by the partial alternating current and to calculate the internal resistance of the second delimitation module (12b) from the alternating-current voltage divided by the overall alternating current of the earthing installation (1).

10. Earthing installation according to any one of claims 1 or 9,
**characterized in that** the measurement value detection unit (11) is additionally configured at the first current measurement resistor (15) to measure the overall direct current flowing over the earthing installation (1) and/or at the second current measurement resistor (16) to measure the partial direct current flowing over the first delimitation module (12a) and **in that** the remote monitoring unit (14) is configured to display the measured direct current values for identifying direct current leakage currents.

11. Method for dissipating alternating current from a steel construction by means of at least one earthing installation, wherein the earthing installation (1) has an earthing electrode (7) which is electrically connected to the steel construction (2), wherein the steel construction (2) is in the form of an underground cathodically protected pipeline which is influenced with alternating current and has a delimitation unit (12) which is electrically connected to the steel construction (2) and the earthing electrode (7) and brings about a direct-current separation of the steel construction (2) from the earthing electrode (7), wherein the earthing installation (1) is electrically connected to a transformer component (9) having a primary winding and a secondary winding, wherein the primary winding is connected in series in the current path of the earthing installation, wherein the alternating current which is dissipated from the earthing installation (1) is fed into the primary winding of the transformer component (9) and wherein the secondary winding provides the charging voltage for an accumulator (10) and wherein by means of a measurement value detection unit (11) current and voltage values of the delimitation unit (12) are continuously or periodically detected and continuously or periodically stored.

12. Method according to claim 11,
**characterized by** the following steps,
- continuously detecting and storing current and voltage values of the earthing installation (1) in situ by means of at least the measurement value detection unit (11) which is supplied with power by means of the accumulator (10),
- transmitting the measurement values to a remote monitoring unit (14) by means of a communication unit (13),
- displaying the alternating-current voltage which influences the steel construction (2) or displaying the dissipated alternating current and/or
- calculating resistance values which are characterizing for the functionality of the earthing installation (1) from the transmitted current and voltage measurement values and displaying the calculated resistance values and/or comparing the calculated resistance values with desired values by means of the remote monitoring unit.

13. Method according to claim 12,
**characterized in that** the communication unit transmits the measurement values of the measurement value detection unit (11) to the remote monitoring unit (14) and **in that** the remote monitoring unit (14) is configured to calculate and display the resistance values which are characterizing for the functionality of the delimitation unit (12) from the measured voltage and current measurement values and/or to compare them with desired values.

## Revendications

1. Installation de mise à la terre pour la dérivation de courant alternatif d'une construction en acier (2),
dans laquelle l'installation de mise à la terre (1) présente une électrode de mise à la terre (7) qui est électriquement reliée à la construction en acier (2),
dans laquelle la construction en acier (2) est configurée comme conduite tubulaire enterrée protégée de manière cathodique et sous l'influence du courant alternatif,
dans laquelle une unité de délimitation (12) est électriquement reliée à la construction en acier (2) et à l'électrode de mise à la terre (7) et provoque une séparation en courant continu de la construction en acier (2) par rapport à l'électrode de mise à la terre (7),
dans laquelle l'installation de mise à la terre présente un composant transformateur (9) avec un enroulement primaire et un enroulement secondaire, dans laquelle le courant alternatif dérivé peut être alimenté dans l'enroulement primaire, dans laquelle l'enroulement primaire est monté en série dans le trajet de courant de l'installation de mise à la terre, dans laquelle l'enroulement secondaire met à disposition la tension de charge pour un accumulateur (10) et dans laquelle une unité de détection de valeur de mesure (11) est conçue afin de détecter en continu ou par périodes des valeurs de courant et de tension de l'unité de délimitation (12) et de les stocker en continu ou par périodes.

2. Installation selon la revendication 1,
**caractérisée en ce que** l'enroulement secondaire du composant transformateur (9) est électriquement relié à une électronique de charge qui est conçue afin de régler et/ou de déplacer la tension de fonctionnement de l'accumulateur et/ou **en ce que** le composant transformateur (9) peut être adapté à différentes zones de courant alternatif.

3. Installation de mise à la terre selon au moins l'une quelconque des revendications précédentes,
**caractérisée en ce qu'**un convertisseur de tension, qui est de préférence réglable, est raccordé à l'accumulateur (10).

4. Installation de mise à la terre selon au moins l'une quelconque des revendications précédentes, **caractérisée en ce que** l'unité de détection de valeur de mesure (11) qui est alimentée en courant par l'accumulateur (10), est conçue afin de mesurer et de stocker en continu ou par périodes des valeurs de courant et de tension de l'installation de mise à la terre.

5. Installation selon la revendication 4,
**caractérisée en ce qu'**une unité de communication (13) est en liaison de communication avec l'unité de détection de valeur de mesure (11) et une unité de télésurveillance (14).

6. Installation selon la revendication 4 ou 5,
**caractérisée en ce que** l'unité de détection de valeur de mesure (11) ou l'unité de télésurveillance (14) est conçue afin d'afficher la tension alternative dérivée et/ou de calculer et d'afficher, à partir des valeurs de mesure de courant et de tension mesurées, les valeurs de résistance qui sont caractérisantes pour la fonctionnalité de l'installation de mise à la terre et/ou de les comparer avec des valeurs de consigne.

7. Installation de mise à la terre selon au moins l'une quelconque des revendications 4 à 6,
**caractérisée en ce que** l'unité de détection de valeur de mesure ou l'unité de télésurveillance (14) est conçue afin de calculer au moins la résistance à la propagation de terre de l'installation de mise à la terre (1), **en ce qu'**une électrode de mise à la terre auxiliaire (8) est montée parallèlement à l'installation de mise à la terre (1), **en ce que** l'installation de mise à la terre (1) présente une première résistance de mesure du courant (15), au niveau de laquelle le courant alternatif entier qui traverse l'installation de mise à la terre (1), peut être mesuré, **en ce que** l'unité de détection de valeur de mesure (11) est conçue afin de mesurer la tension alternative entre l'électrode de mise à la terre (7) et la construction en acier (2) et la tension alternative entre l'électrode de mise à la terre (7) et l'électrode de mise à la terre auxiliaire (8) et **en ce que** l'unité de détection de valeur de mesure ou l'unité de télésurveillance (14) est conçue afin de calculer la résistance à la propagation de terre de l'installation de mise à la terre (19) à partir de la différence des tensions alternatives mesurées divisée par le courant alternatif entier mesuré.

8. Installation selon la revendication 1,
**caractérisée en ce que** l'unité de détection de valeur de mesure (11) est conçue afin de mesurer et de stocker des valeurs de courant et de tension de l'unité de délimitation (12), **en ce que** l'unité de détection de valeur de mesure ou l'unité de télésurveillance (14) est conçue afin de calculer et d'afficher à partir des valeurs de mesure de courant et de tension mesurées les valeurs de résistance qui sont caractérisantes pour la fonctionnalité de l'unité de délimitation (12) et/ou de les comparer avec des valeurs de consigne.

9. Installation selon la revendication 1,
**caractérisée en ce que** l'unité de délimitation (12) présente un premier module de délimitation (12a) et un second module de délimitation (12b) monté en parallèle de celui-ci, **en ce que** le premier module de délimitation (12a) est configuré comme circuit résonant série, **en ce que** le second module de délimitation (12b) présente un commutateur (12b') qui se ferme lorsqu'une tension alternative induite dans la conduite tubulaire dépasse une valeur seuil de tension alternative réglée, **en ce qu'**une seconde résistance de mesure de courant (16) se trouve dans le premier module de délimitation (12a) configuré comme circuit résonant série et **en ce que** l'unité de détection de valeur de mesure (11) est conçue afin de mesurer la tension alternative par le biais de l'installation de mise à la terre, de mesurer le courant alternatif entier qui traverse l'installation de mise à la terre (1), au niveau de la première résistance de mesure de courant (15) et le courant alternatif partiel qui traverse le premier module de délimitation (12a), au niveau de la seconde résistance de mesure de courant (16) et **en ce que** l'unité de détection de valeur de mesure (11) ou l'unité de télésurveillance (14) est conçue afin de calculer la résistance intérieure du premier module de délimitation (12a) à partir de la tension alternative de l'installation de mise à la terre (1) divisée par le courant alternatif partiel et de calculer la résistance intérieure du second module de délimitation (12b) à partir de la tension alternative divisée par le courant alternatif entier de l'installation de mise à la terre (1).

10. Installation de mise à la terre selon l'une quelconque des revendications 1 ou 9,
**caractérisée en ce que** l'unité de détection de valeur de mesure (11) est en outre conçue afin de mesurer au niveau de la première résistance de mesure de courant (15) le courant continu entier qui traverse l'installation de mise à la terre (1) et/ou au niveau de la seconde résistance de mesure de courant (16) le courant continu partiel qui traverse le premier module de délimitation (12a) et **en ce que** l'unité de télésurveillance (14) est conçue afin d'afficher les valeurs de courant continu mesurées pour la détection de courants de fuite de courant continu.

11. Procédé de dérivation de courant alternatif d'une construction en acier au moyen d'au moins une installation de mise à la terre, dans lequel l'installation de mise à la terre (1) présente une électrode de mise à la terre (7) qui est électriquement reliée à la construction en acier (2), dans lequel la construction en acier (2) est configurée comme conduite tubulaire enterrée protégée de manière cathodique et sous l'influence du courant alternatif et présente une unité de délimitation (12) qui est électriquement reliée à la construction en acier (2) et à l'électrode de mise à la terre (7) et provoque une séparation en courant continu de la construction en acier (2) par rapport à l'électrode de mise à la terre (7), dans lequel l'installation de mise à la terre (1) est électriquement reliée à un composant transformateur (9) avec un enroulement primaire et un enroulement secondaire, dans lequel l'enroulement primaire est monté en série dans le chemin de courant de l'installation de mise à la terre, dans lequel le courant alternatif dérivé de l'installation de mise à la terre (1) est alimenté dans l'enroulement primaire du composant transformateur (9) et dans lequel l'enroulement secondaire met à disposition la tension de charge pour un accumulateur (10) et dans lequel des valeurs de courant et de tension de l'unité de délimitation (12) sont détectées en continu et par périodes au moyen d'une unité de détection de valeur de mesure (11) et sont enregistrées en continu ou par périodes.

12. Procédé selon la revendication 11,
**caractérisé par** les étapes suivantes :
- la détection et l'enregistrement continus de valeurs de courant et de tension de l'installation de mise à la terre (1) sur site au moyen d'au moins l'unité de détection de valeur de mesure (11) qui est alimentée en courant au moyen de l'accumulateur (10),
- la transmission de valeurs de mesure au moyen d'une unité de communication (13) à une unité de télésurveillance (14),
- l'affichage de la tension alternative qui influence la construction en acier (2) ou l'affichage du courant alternatif dérivé et/ou
- le calcul de valeurs de résistance qui sont caractérisantes pour la fonctionnalité de l'installation de mise à la terre (1), à partir des valeurs de mesure de courant et de tension transmises et l'affichage des valeurs de résistance calculées et/ou la comparaison des valeurs de résistance calculées avec des valeurs de consigne au moyen de l'unité de télésurveillance.

13. Procédé selon la revendication 12,
**caractérisé en ce que** l'unité de communication transmet les valeurs de mesure de l'unité de détection de valeur de mesure (11) à l'unité de télésurveillance (14) et **en ce que** l'unité de télésurveillance (14) est conçue afin de calculer et d'afficher, à partir des valeurs de mesure de courant et de tension transmises, les valeurs de résistance qui sont caractérisantes pour la fonctionnalité de l'unité de délimitation (12) et/ou de les comparer avec des valeurs de consigne.
